# FASCICULE DE BREVET EUROPEEN

(11) **EP 2 289 134 B1**
(45) Date de publication et mention de la délivrance du brevet: **25.04.2012**
(21) Numéro de dépôt: 09761892.0
(22) Date de dépôt: 12.05.2009
(51) Int. Cl.: H01S 5/10, H01S 1/02, H01S 5/34

(54) **DISPOSITIF LASER D'ÉMISSION D'ONDE TÉRAHERTZ**
LASERGERÄT MIT TERAHERTZWELLENEMISSION
TERAHERTZ WAVE EMISSION LASER DEVICE

(30) Priorité: 13.06.2008 FR 0853939
(43) Date de publication de la demande: 02.03.2011
(73) Titulaire: COMMISSARIAT A L'ENERGIE ATOMIQUE ET AUX ENERGIES ALTERNATIVES, 75015 Paris (FR); Université Paris Diderot - Paris 7, 75205 Paris Cedex 13 (FR)
(72) Inventeur: CLAUDON, Julien, F-38950 Saint Martin Le Vinoux (FR); GERARD, Jean-Michel, F-38410 Saint Martin d'Uriage (FR); BERGER, Vincent, F-94200 Ivry-sur-Seine (FR); LEO, Guiseppe, F-94300 Vincennes (FR); ANDRONICO, Alessio, F-00159 Rome (FR)
(74) Mandataire: Lebkiri, Alexandre
(86) Numéro de dépôt international: PCT/FR2009/050872
(87) Numéro de publication internationale: WO 2009/150341

(56) Documents cités:
- US-B1- 6 541 295
- G. FASCHING ET AL: "Microcavity terahertz quantum-cascade laser" INFRARED TO TERAHERTZ TECHNOLOGIES FOR HEALTH AND THE ENVIRONMENT 24 OCT. 2005 BOSTON, MA, USA, vol. 6010, no. 1, 9 novembre 2005 (2005-11-09), pages 601006-1-601006-11, XP002512463 Proceedings of the SPIE - The International Society for Optical Engineering SPIE - The International Society for Optical Engineering USA ISSN: 0277-786X
- C. BRENNER ET AL: "Room temperature terahertz generation with semiconductor lasers" PROCEEDINGS OF THE SPIE, vol. 6194, 19 juin 2006 (2006-06-19), pages 61940H-1-61940H-8, XP002512464 Strassbourg
- Y. DUMEIGE ET AL: "Second harmonic generation using tailored whispering gallery modes" Physical Review A (Atomic, Molecular, and Optical Physics) American Physical Society through AIP USA, vol. 76, no. 3, 1 septembre 2007 (2007-09-01), pages 035803-1-035803-4, XP002512465 stevenage ISSN: 1050-2947

## Description

La présente invention concerne un dispositif laser d'émission d'onde dans une gamme de fréquence comprise entre 0,5 THz et 5 THz.

Le domaine Térahertz (THz) du spectre électromagnétique est compris entre les micro-ondes et l'infrarouge lointain et s'étale de 500 GHz (0,5 THz) à 5 THz (typiquement 1 THz correspond à une énergie de 4 meV ou encore à une longueur d'onde dans le vide de 300 µm).

Les sources THz trouvent leurs principales applications dans la spectroscopie et l'imagerie dans les domaines de la sécurité et de la médecine. Elles peuvent par ailleurs être employées pour les télécommunications en espace libre à courte distance (par exemple à l'intérieur des immeubles) pour l'analyse non destructive d'aliments, de couches de finition, de circuits intégrés. Les technologies THz sont décrites de façon générale dans les documents « Cutting-edge terahertz technology » (M. Tonouchi, Nature Photonics, février 2007, p. 97) et « Terahertz technology : a land to be discovered » (M. Koch, Optics and Photonics News, mars 2007, p. 21).

Dans le contexte de la spectroscopie THz, on distingue en général la spectroscopie à large bande dans le domaine temporel (THz-TDS ou « THz Time Domain Spectroscopy ») et la spectroscopie utilisant une source THz monochromatique (CW ou «Continuous Wave »). De par leur résolution fréquentielle intrinsèquement limitée, les systèmes TDS sont surtout employés pour la spectroscopie de structures à faibles facteurs de qualité. En effet, dans une expérience de TDS typique, la fenêtre de temps est de 100 ps, d'où une résolution fréquentielle de 5 GHz. D'un autre côté, les sources THz continues et monochromatiques CW ont trouvé un vaste champ d'applications en spectroscopie astronomique ou dans l'étude des réactions chimiques se déroulant dans la haute atmosphère, où les résonances THz mises en jeu ont souvent des facteurs de qualité entre 10² et 10⁶.

La spectroscopie THz présente par ailleurs de grandes applications en sécurité civile et militaire, par exemple dans la détection d'agents chimiques ou d'explosifs. Dans toutes les situations où le produit analysé se trouve en phase gazeuse, les spectres acquis par une méthode CW ont une résolution bien supérieure à celle des spectres obtenus par une méthode TDS. La technologie TDS est quant à elle très largement utilisée pour la caractérisation de matériaux en phase condensée.

Concernant les sources TDS, les sources traditionnelles de rayonnement THz, comme les lasers à gaz ou les oscillateurs « backward wave oscillators », sont chères et encombrantes. Les sources THz reposant sur des ensembles d'oscillateurs solides sont aussi onéreuses. Aujourd'hui, les dispositifs les plus utilisés pour générer et détecter des impulsions THz large bande sont les antennes dipolaires photoconductrices excitées par un laser femtoseconde, qui est souvent coûteux et volumineux. De tels dispositifs sont décrits dans le document "Sensing with Terahertz Radiation" (D. Mittleman Springer-Verlag, Heidelberg (2003)).

On connaît par ailleurs différentes sources de type CW.

Une première source connue de type monochromatique CW utilise la technique de photomélange ou « Photomixing » l'hétérodynage optique permet de générer une onde THz continue. Le battement de deux diodes laser continues émettant autour de 800 nm et désaccordées de quelques THz induit une oscillation de charge dans la bande de conduction d'un semiconducteur tel que GaAs ou InGaAs semi-isolants.

Toutefois, les démonstrateurs réalisés à ce jour sont des systèmes non intégrés et les puissances THz maximales générées restent relativement faibles, de l'ordre de 100 nW, comme le montrent les documents "Photomixing up to 3,8 THz in low-temperature-grown GaAs" (E. R. Brown et al., Appl. Phys. Lett. 66, 285, (1995)) et "Generation and détection of coherent terahertz waves using two photomixers" (S. Verghese et al., Appl. Phys. Lett. 73, 3824 (1998)).

Les lasers à cascade quantique constituent un second type de sources monochromatiques CW dans le domaine THz. De telles sources sont décrites dans les documents "Terahertz semiconductor-heterostructure laser", R. Kohler et al., Nature 417, 156 (2002) Microcavity terahertz quantum-cascade laser", G. Fasching et al., Infrared to Terahertz technologies for Health and the Environment Proceedings of the SPIE vol.6010, 601006-1 to 601006-11. (9-11-2005). Ces sources permettent de générer une puissance plus élevée, mais elles sont peu accordables et ne fonctionnent qu'aux températures cryogéniques. Pour cette dernière raison, ces sources sont des systèmes encombrants et complexes.

Une troisième source connue de type CW utilise la technique de conversion de fréquence. Les effets non linéaires du second ordre sont ainsi utilisés pour la génération et l'amplification de THz, en suivant différentes approches :
- mélange de lasers moyen infrarouge dans du GaAs massif tel que décrit dans le document "Noncolinear phase matching in GaAs" (L. Aggarwal et al., Appl. Phys. Lett. 22, 239, (1973)) ;
- mélange d'impulsions ultra brèves proches infrarouges dans des cristaux tels que ZnSe, LiNbO₃ tel que décrit dans le document "Generation of Far-Infrared Radiation by Picosecond Light Pulses in LiNbO3" (K. H. Yang et al., Appl. Phys. Lett. 19, 320, (1971)), ou LiNbO₃ retourné périodiquement (PPLN ou « Periodically Poled Lithium Niobate ») tel que décrit dans le document « Generation of narrow-band terahertz radiation via optical rectification of femtosecond pulses in periodically poled lithium niobate » (Y.-S. Lee et al.,Appl. Phys. Lett. 76, 2505 (2000)).

De par son fort coefficient non linéaire et ses faibles pertes dans le domaine THz (~1 cm⁻¹), le GaAs constitue un matériau de choix pour ces applications. Le document "Terahertz-wave generation in quasi-phase-matched GaAs" (K. L. Vodopyanov et al., Appl. Phys. Lett. 89, 141119, (2006)) décrit la génération d'ondes THz de 0,9 à 3 THz dans du GaAs périodiquement inversé, avec une efficacité de conversion de 10⁻³ en utilisant deux faisceaux de pompe au voisinage de 3 µm.

Toutefois, tous ces systèmes ne sont ni compacts, ni aisés à mettre en oeuvre hors d'un laboratoire de recherche.

Le document "Nonlinear phase matching in THz semiconductor waveguides" (V. Berger and C. Sirtori, Semicond. Sci. Technol. 19, 964 (2004)) propose d'exploiter la dispersion anormale créée par l'absorption par la bande de phonon dans GaAs pour accorder en phase deux faisceaux de pompe proche IR (Infrarouge) et le faisceau THz généré dans un guide d'onde de type « ridge »; cette proposition n'a pas encore fait l'objet d'une démonstration expérimentale. Par ailleurs, tout comme les autres solutions, elle ne permet pas d'obtenir un système compact.

Dans ce contexte, la présente invention a pour but de fournir un dispositif laser compact d'émission d'onde lumineuse dans une gamme de fréquence comprise entre 0,5 THz et 5 THz permettant de s'affranchir des limitations mentionnées ci-dessus en termes d'encombrement, de complexité et de coût.

A cette fin, l'invention propose un dispositif laser d'émission d'onde dans une gamme de fréquence comprise entre 0,5 THz et 5 THz comportant une hétérostructure semiconductrice, ledit dispositif étant caractérisé en ce que ladite hétérostructure est de forme cylindrique à section circulaire, ladite hétérostructure comportant :
- une première couche en matériau semiconducteur optiquement non linéaire incluant des moyens émetteurs aptes à émettre dans au moins deux modes de galerie optiques appartenant au proche infrarouge, lesdits au moins deux modes de galerie étant confinés dans ladite première couche et permettant la génération au sein de ladite première couche d'un rayonnement dans un mode de galerie électromagnétique de fréquence comprise entre 0,5 THz et 5 THz, dit mode Térahertz, ledit rayonnement étant obtenu par différence des fréquences desdits deux modes de galerie, la géométrie cylindrique de ladite hétérostructure assurant l'accord de phase entre les deux modes de galerie optiques appartenant au proche infrarouge et le mode Térahertz à la fréquence différence;
- une deuxième et une troisième couche en matériau semiconducteur présentant chacune un indice optique plus faible que l'indice du matériau utilisé pour ladite première couche et situées de part et d'autre de ladite première couche ;
- au moins une couche métallique située à une extrémité de ladite hétérostructure.

On entend par proche infrarouge un rayonnement de longueur d'onde comprise entre 0,7 µm et 1,4 µm.

On entend par mode de galerie optique un mode résultant de la réflexion de rayons lumineux sur la paroi cylindrique intérieure de la première couche formant microcavité réalisée dans un matériau dont l'indice de réfraction est plus élevé que le milieu qui l'entoure (i.e. l'air). Les rayons restent en général confinés le long de la paroi cylindrique et ne passent pas par le centre de la microcavité.

Grâce à l'invention, l'onde THz est générée par différence de fréquence (i.e. conversion paramétrique) à partir de deux modes de galerie appartenant au proche infrarouge et présents dans ladite première couche centrale formant microcavité de type microcylindre : la réflexion sur l'interface semiconducteur-air du microcylindre conduit à la formation de modes de galerie THz. Les modes de galerie à très haut facteur de qualité sont excités par des émetteurs tels que des boîtes ou des puits quantiques. Les émetteurs sont préférentiellement pompés électriquement mais peuvent également être pompés optiquement.

Le dispositif selon l'invention permet l'émission continue ou quasi continue de radiations électromagnétiques THz.

La géométrie cylindrique de l'invention avec des émetteurs à l'intérieur de la première couche cylindrique permet d'aboutir à la génération de hautes puissances THz au sein d'une source compacte. La symétrie cylindrique de la première couche centrale en matériau semiconducteur optiquement non linéaire tel que du GaAs favorise l'accord de phase entre les modes de galerie optiques et le mode THz.

La couche métallique située à une extrémité de l'hétérostructure cylindrique assure le confinement vertical du mode THz selon le principe des guides métalliques plasmoniques. Ce confinement permet d'augmenter l'efficacité du rendement de conversion non linéaire. La couche métallique permet également l'injection des porteurs de charge dans le cas d'un pompage électrique des émetteurs.

La géométrie selon l'invention permet par ailleurs d'optimiser simultanément et indépendamment le confinement vertical des modes de galerie optiques et celui du mode THz, en jouant sur les épaisseurs des différentes couches, en particulier les épaisseurs des deuxième et troisième couches en matériau semiconducteur tel que du AlGaAs. Ceci permet de maximiser le recouvrement entre les modes optiques et le mode THz. On notera que les deuxième et troisième couches permettent non seulement de régler l'espacement entre le miroir et la couche active comportant les émetteurs mais également de réaliser le confinement optique latéral du mode THz.

La géométrie selon l'invention offre en outre, de par sa forme cylindrique sans étranglement, une bonne évacuation de la chaleur vers le substrat, assurant la stabilité en puissance des propriétés du laser et permettant d'atteindre des puissances laser compatibles avec la génération non linéaire de THz.

Selon un mode particulièrement avantageux de l'invention, ladite hétérostructure de forme cylindrique comporte une zone centrale semi-isolante s'étendant sensiblement entre les deux extrémités de ladite hétérostructure.

Cette zone centrale permet d'améliorer les performances du dispositif selon l'invention, lorsque ce dernier est pompé électriquement, puisque le courant de pompe est alors efficacement canalisé dans la zone active du dispositif, c'est-à-dire la circonférence de la première couche active qui supporte les modes de galerie proches infrarouges.

Le dispositif selon l'invention peut également présenter une ou plusieurs des caractéristiques ci-dessous, considérées individuellement ou selon toutes les combinaisons techniquement possibles :
- ledit dispositif selon l'invention comporte deux couches métalliques situées chacune à une extrémité de ladite hétérostructure ;
- ladite ou lesdites couches métalliques sont réalisées en or ;
- lesdits moyens émetteurs sont réalisés selon l'une des formes suivantes :
   - un ou une pluralité de puits quantiques ;
   - un ou une pluralité de plans de boites quantiques ;
   - une ou une pluralité de structures à cascade quantique ;
- ledit matériau semiconducteur optiquement non linéaire de ladite première couche est un matériau III-V tel que le GaAs ou InGaAsP ou un matériau II-VI ;
- le matériau semiconducteur desdites deuxième et troisième couche est du AlₓGa₁₋ₓAs avec 0,2<x<0,6 ou de l'InP ;
- ladite deuxième couche semiconductrice est une couche dopée p et ladite troisième couche semiconductrice est une couche dopée n ;
- ladite première couche inclut une pluralité de plans d'émetteurs ;
- ladite hétérostructure de forme cylindrique comporte deux couches semi-conductrices, dites couches de protection contre l'oxydation, recouvrant respectivement lesdites deuxième et troisième couches ;
- chacune desdites couches de protection contre l'oxydation a une épaisseur comprise entre 2 et 10 nm ;
- l'épaisseur desdites deuxième et troisième couche est comprise entre 0,5 et 5 µm ;
- le dispositif selon l'invention comporte deux contacts électriques pour l'injection d'un courant de pompage desdits moyens émetteurs ;
- l'épaisseur de ladite première couche est comprise entre 200 et 400 nm ;
- le diamètre de ladite hétérostructure cylindrique est compris entre 30 et 100 µm ;
- ladite première couche est une couche non intentionnellement dopée.

La présente invention a également pour objet un système cryogénique intégrant un dispositif selon l'invention.

La présente invention a également pour objet un réseau comportant une pluralité de dispositifs selon l'invention, caractérisé en ce que chacun desdits dispositifs présente sensiblement la même fréquence.

Selon un premier mode de réalisation, lesdits dispositifs du réseau sont suffisamment proches les uns des autres pour coupler les champs évanescents THz des différents dispositifs.

Selon un second mode de réalisation, une partie du rayonnement THz émis par ledit réseau est réinjectée dans ledit réseau.

La présente invention a également pour objet un réseau comportant une pluralité de dispositifs selon l'invention, caractérisé en ce que chacun desdits dispositifs présente des fréquences THz différentes, chacun desdits dispositifs étant commandés individuellement.

Enfin, la présente invention a pour objet un procédé de réalisation d'un dispositif selon l'invention, caractérisé en ce qu'il comporte les étapes suivantes :
- Croissance épitaxiale par dépôt sur un substrat semiconducteur d'une structure comportant au moins les couches suivantes dans cet ordre à partir du substrat :
   - une couche semiconductrice sacrificielle ;
   - une première couche semiconductrice de protection ;
   - une couche réalisée dans un matériau semiconducteur identique à celui de ladite deuxième couche ;
   - une couche réalisée dans un matériau semiconducteur identique à celui de ladite première couche, ladite couche comportant des moyens émetteurs ;
   - une couche réalisée dans un matériau semiconducteur identique à celui de ladite troisième couche ;
   - une deuxième couche semiconductrice de protection ;
- Report sur un substrat hôte préalablement métallisé de ladite structure épitaxiée de sorte que la deuxième couche de protection est en contact avec le métal dudit substrat hôte;
- Amincissement dudit substrat semiconducteur par abrasion mécanique ;
- Attaque chimique sélective dudit substrat sur l'épaisseur restante, ladite couche sacrificielle étant utilisée comme couche d'arrêt ;
- Attaque chimique sélective de ladite couche sacrificielle, ladite première couche de protection étant utilisée comme couche d'arrêt ;
- Réalisation d'un masque définissant une ouverture de diamètre inférieure au diamètre de l'hétérostructure de forme cylindrique ;
- Implantation ionique rendant semi-isolante la zone non protégée par ledit masque;
- Elimination dudit masque ;
- Dépôt d'une couche métallique circulaire de diamètre égal au diamètre de l'hétérostructure de forme cylindrique;
- Gravure des parties non recouvertes par ladite couche métallique circulaire de façon à former l'hétérostructure de forme cylindrique.

Avantageusement, ledit masque définit une ouverture de diamètre inférieur de 1 à 2 µm au diamètre de l'hétérostructure de forme cylindrique.

D'autres caractéristiques et avantages de l'invention ressortiront clairement de la description qui en est donnée ci-dessous, à titre indicatif et nullement limitatif, en référence aux figures annexées, parmi lesquelles :
- les figures 1 a à 1 c illustrent un exemple de réalisation d'un dispositif laser selon l'invention;
- les figures 2 a à 2 f illustrent les différentes étapes d'un procédé de fabrication d'un dispositif tel que représenté aux figures 1 a à 1 c ;
- la figure 3 représente schématiquement un réseau intégrant une pluralité de dispositifs selon l'invention et formant une source agile en fréquence.

Dans toutes les figures, les éléments communs portent les mêmes numéros de référence.

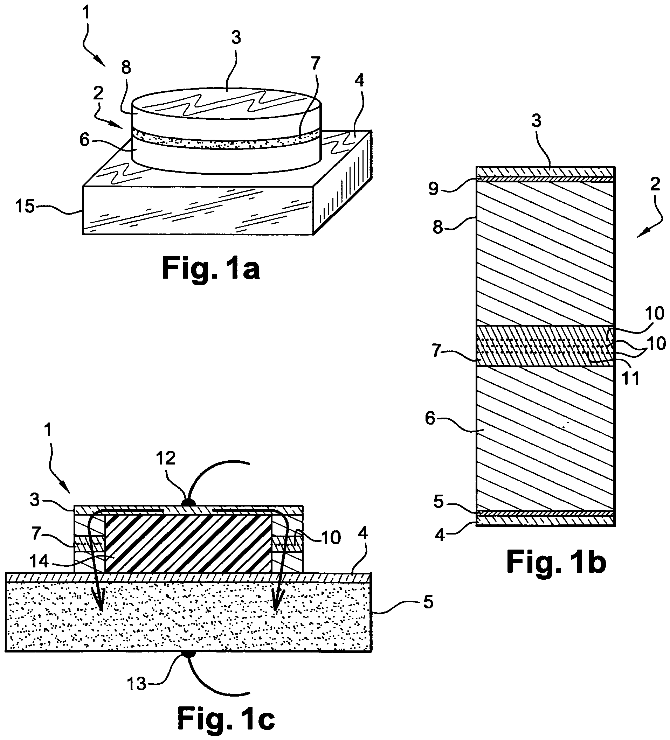

La figure 1a représente un mode de réalisation d'un dispositif laser 1 selon l'invention.

La figure 1c est une vue en coupe selon un plan vertical de ce même dispositif 1.

Le dispositif 1 selon l'invention est une source continue ou quasi continue de radiations électromagnétiques THz. La génération du rayonnement THz est assurée par conversion paramétrique (i.e. différence de fréquences) à partir de deux modes optiques d'un microlaser semiconducteur à modes de galerie.

Le dispositif 1 comporte ainsi une hétérostructure semiconductrice 2 cylindrique dont les extrémités sont chacune couvertes d'une couche métallique (par exemple en or) formant respectivement un miroir supérieur 3 et un miroir inférieur 4. Le diamètre de l'hétérostructure cylindrique 2 est typiquement compris entre 30 et 100 µm.

Cette hétérostructure semiconductrice 2 repose sur un substrat hôte 15 bon conducteur de la chaleur et de l'électricité, par exemple un substrat métallique ou un substrat GaAs dopé.

La figure 1b représente les différentes couches de l'hétérostructure semiconductrice 2 à géométrie cylindrique.

Ainsi cette hétérostructure 2 comporte de bas en haut :
- le miroir inférieur 4 ;
- une fine couche 5 (quelques nm, typiquement entre 2 et 10 nm) de GaAs dopée n ;
- une couche 6 d'alliage AlₓGa₁₋ₓAs dopée n (avec typiquement 0,2<x<0,6) dont l'indice optique est plus faible que celui du GaAs et dont l'épaisseur est par exemple comprise entre 0,5 et 5 µm et préférentiellement comprise entre 0,5 et 3 µm;
- une couche active 7 ;
- une couche 8 d'alliage AlₓGa₁₋ₓAs dopée p (avec typiquement 0,2<x<0,6) dont l'indice optique est plus faible que celui du GaAs et dont l'épaisseur est par exemple comprise entre 0,5 et 5 µm et préférentiellement comprise entre 0,5 et 3 µm;
- une fine couche 9 (quelques nm, typiquement entre 2 et 10 nm) de GaAs dopée n ;
- le miroir supérieur 3.

La couche active 7 est une couche de GaAs non intentionnellement dopée ayant une épaisseur typiquement comprise entre comprise entre 200 et 400 nm (par exemple 300 nm). La couche 7 de GaAs contient de plus un milieu émetteur, ici une pluralité de plans 10 de boîtes quantiques 11 : un seul plan de boites quantiques peut être suffisant et on peut également utiliser un ou plusieurs puits quantiques. Le milieu émetteur est ici pompé électriquement. Deux contacts électriques 12 et 13 sont prévus à cet effet et représentés sur la figure 1c qui est une coupe selon un plan vertical du dispositif 1 tel que représenté en figure 1 a. Le contact 12 est ici réalisé sur le miroir supérieur 3 qui fait donc également office d'électrode supérieure d'injection. Le contact 13 est réalisé en face arrière du substrat hôte 15 (nous verrons lors de la description du procédé de fabrication que d'autres configurations de contact peuvent être envisagées). Le milieu émetteur pompé électriquement suppose bien entendu un dopage adéquat de l'hétérostructure semiconductrice 2. Ainsi, comme décrit plus haut, la couche 6 d'AlₓGa₁₋ₓAs inférieure et la fine couche 5 de GaAs en contact avec le miroir inférieur 4 sont dopées n tandis que la couche 8 d'AlₓGa₁₋ₓAs supérieure et la fine couche 9 de GaAs en contact avec le miroir supérieur 3 sont dopées p.

On notera que les fines couches 5 et 9 ne sont représentés qu'en figure 1b par souci de simplification des figures 1 a et 1 c.

Le milieu émetteur 10 fournit le gain nécessaire pour faire laser simultanément plusieurs modes optiques de galerie dans le proche infrarouge. Comme déjà mentionné plus haut, on entend par proche infrarouge un rayonnement de longueur d'onde comprise entre 0,7 µm et 1,4 µm et par mode de galerie optique un mode résultant de la réflexion de rayons lumineux sur la paroi intérieure de la couche 7 de GaAs formant microcavité cylindrique. Les rayons restent confinés le long de la paroi et ne passent pas par le centre de la microcavité. La génération du mode THz est assurée par différence de fréquences à partir des deux modes de galerie. La difficulté de l'obtention de la génération paramétrique est liée à la nécessité de ce que l'homme du métier appelle l'accord de phase : du à la dispersion de l'indice optique avec la longueur d'onde, les différentes ondes interagissant (modes optiques proche IR et mode THz) ne se déplacent pas à la même vitesse dans le matériau. Il en résulte que l'interaction non linéaire peut rapidement devenir destructive et le processus perd de son efficacité. Pour obtenir une génération paramétrique efficace, il est donc nécessaire d'obtenir l'accord de phase qui assure le maintien d'une interaction constructive tout le long de la propagation. La géométrie cylindrique du dispositif 1 permet de réaliser l'accord de phase entre les deux modes du microlaser et le mode THz à la fréquence différence. Des travaux récents, décrit par exemple dans le document "Whispering-gallery-mode analysis of phase-matched doubly resonant second-harmonic generation" (Y. Dumeige and P. Féron,Phys. Rev. A 74, 063804 (2006)) montrent qu'un choix judicieux de modes de galerie permet de réaliser un quasi-accord de phase dans un microcylindre de GaAs, et d'obtenir potentiellement une interaction non linéaire efficace dans le cas du doublage de fréquence.

L'utilisation d'une couche active 7 à base de GaAs présente des avantages importants liés à ce matériau :
- Sa technologie très mature,
- Son fort indice optique,
- Son coefficient non linéaire élevé.

Tandis que le premier point permet de réaliser des dispositifs compacts à faible coût, le fort confinement optique et la non-linéarité élevée sont susceptibles de donner lieu à des forts rendements de conversion.

Le confinement des deux modes de galerie proche IR est assuré par la couche active 7. La géométrie cylindrique de la couche active 7 assure un confinement vertical de la lumière proche infrarouge (λ~1 µm) et la réflexion sur l'interface semiconducteur-air de cette couche microcylindrique 7 donne naissance à des modes de galerie proches infrarouges. Les modes de galerie sont caractérisés par leur polarisation - transverse électrique (TE) ou transverse magnétique TM - et par trois nombres entiers, qui caractérisent leur ordre vertical (correspondant à l'ordre du mode suivant la direction verticale du cylindre), radial (correspondant à l'ordre du mode suivant le rayon du cylindre) et azimutal. La couche active 7 ne permet en revanche pas le confinement du mode THz.

Le confinement vertical du mode THz est assuré par les deux miroirs supérieur et inférieur 3 et 4. Ces deux miroirs métalliques 3 et 4 forment un guide pour les ondes électromagnétiques THz et assurent un confinement vertical record du mode THz, selon le principe des guides métalliques plasmoniques pour les ondes THz ; un tel type de confinement est décrit dans le document "Terahertz quantum-cascade laser at λ = 100 µm using metal waveguide for mode confinement" (B. S. Williams et al., Appl. Phys. Lett. 83, 2124 (2003)). Ce confinement permet d'augmenter l'efficacité du rendement de conversion non linéaire dans le cadre du dispositif 1 selon l'invention. On notera que le principe de guide métallique plasmonique peut également s'appliquer avec un seul miroir (dans ce cas, le confinement vertical du mode THz est également de type plasmonique mais avec un seul miroir autorisant une excitation optique des émetteurs, la présence d'un seul miroir entraînant cependant une perte en confinement du mode THz). La réflexion sur l'interface semiconducteur-air du microcylindre 7 conduit à la formation de modes de galerie THz. Les couches 6 et 8 d'AlₓGa₁₋ₓAs permettent d'éloigner le mode guidé des miroirs métalliques 3 et 4 et de limiter les pertes optiques par absorption dans le métal. Les modes optiques infrarouges confinés dans la couche active centrale de GaAs, ont en effet tendance à « baver » dans les couches 6 et 8 d'AlₓGa₁₋ₓAs. Dès lors, si les miroirs métalliques sont trop près de la couche centrale, les modes optiques infrarouges sont susceptibles d'être absorbés par le métal. L'épaisseur des couches 6 et 8 d'AlₓGa₁₋ₓAs est donc choisie de manière à minimiser les pertes des modes optiques infrarouges. Les couches 6 et 8 assurent donc un rôle d'espaceur entre la couche active 7 et les miroirs 3 et 4. Ces couches 6 et 8, de par leur indice élevé, assurent par ailleurs un confinement latéral du mode THz.

La coupe verticale du dispositif 1 telle qu'illustrée en figure 1c représente une zone semi-isolante 14 correspondant à la partie centrale de l'hétérostructure 2. Cette zone 14 est sensiblement cylindrique (concentrique au cylindre formé par l'hétérostructure 2). Comme nous le verrons plus tard en référence à la description du procédé de fabrication, cette zone semi-isolante 14 peut être par exemple obtenue par une étape d'implantation ionique. Cette zone 14 permet d'améliorer les performances du dispositif 1 selon l'invention puisque le courant de pompe est alors efficacement canalisé dans la zone active du dispositif 1, c'est-à-dire la circonférence de la couche active 7 de GaAs qui supporte les modes de galerie proches infrarouges. Les flèches illustrent le passage du courant de pompe au sein du dispositif 1.

Selon l'invention, la même hétérostructure semiconductrice 2 assure les fonctions de source laser de pompe et de conversion de fréquence. Cette approche permet potentiellement d'éliminer tous les problèmes d'alignement optique et simplifie énormément le packaging du dispositif 1 selon l'invention. Elle aboutit à un dispositif 1 émetteur de radiation THz extrêmement compact.

On notera qu'il est également possible d'inverser les couches dopées p et n (i.e. faire passer les couches ayant un dopage n au niveau supérieur et les couches ayant un dopage p au niveau inférieur) sans sortir du cadre de l'invention : les prises de contact électrique devront bien entendu être adaptées au type de dopage.

A titre purement illustratif, on trouvera ci-dessous un exemple de dimensionnement du dispositif 1 selon l'invention : on sait que la séparation spectrale entre modes de galerie dépend de l'indice effectif du mode guidé et du diamètre du cylindre. Le diamètre sera donc choisi de façon à obtenir une émission THz dans la gamme spectrale voulue, et à réaliser la condition d'accord de phase entre les deux modes proches-infrarouges et le mode THz. Considérons à titre d'exemple la structure définie par les paramètres suivants :
- épaisseur de la couche guide active 7 en GaAs : 325 nm ;
- composition et épaisseur des couches espaceurs 6 et 8 de confinement optique : Al_{0,6}Ga_{0,4}As, 2800 µm
- diamètre de l'hétérostructure cylindrique 2: 42 µm

Dans l'exemple illustré ci-dessus, le calcul des modes de galerie de la structure montre que l'accord de phase est obtenu entre les modes proches-infrarouges TE_{0,1,946} (λ= 0,917 µm) et TE _{0,1,948} (λ= 0,905 µm), et le mode THz TM_{0,1,4} (λ= 70 µm ou 4,3 THz).

Concernant le choix du milieu émetteur, on notera que les microlasers à mode de galerie utilisant comme émetteur un ou des puits quantiques tendent à présenter un comportement monomode pour des courants d'injection nettement supérieurs au courant de seuil. L'élargissement de la courbe de gain du puits quantique est en effet de nature homogène, ce qui permet une compétition entre modes au-dessus du seuil. Les boîtes quantiques apportent ici une solution potentiellement plus performante car leur courbe de gain présente naturellement un fort élargissement inhomogène (60 à 100 meV pour des boîtes d'InAs dans GaAs), du fait de la dispersion en taille des boîtes quantiques. Dans ces conditions, plusieurs modes de galerie se trouvent dans la bande d'amplification du milieu actif. La largeur homogène du gain, de l'ordre de 10 meV à température ambiante, est nettement plus faible que sa largeur inhomogène, ce qui permet d'observer l'effet laser pour plusieurs modes de galerie.

En termes de performances du dispositif laser 1 selon l'invention, la géométrie microcylindre est supérieure à celle d'un microdisque car elle permet une bonne évacuation de la chaleur vers le substrat, assurant la stabilité en puissance des propriétés du laser et permettant d'atteindre des puissances laser compatibles avec la génération non linéaire de THz.

La géométrie cylindrique du dispositif 1 selon l'invention avec des émetteurs à l'intérieur permet d'aboutir à la génération de hautes puissances THz au sein d'une source compacte. Cette géométrie présente les avantages suivants :
- La symétrie cylindrique de la partie centrale en GaAs favorise l'accord de phase entre les modes optiques et le mode THz.
- Elle permet d'optimiser simultanément et indépendamment le confinement vertical des modes de galerie optiques et celui du mode THz, en jouant sur les épaisseurs des différentes couches (particulièrement les couches de confinement optique en AIGaAs). Ceci permet de maximiser le recouvrement entre les modes optiques et le mode THz.
- La zone centrale semi-isolante permet une injection efficace des porteurs de charges à la périphérie de la couche centrale de GaAs, qui supporte les modes de galerie optiques.
- La géométrie cylindrique permet une bonne évacuation de la chaleur vers le substrat, assurant la stabilité en puissance des propriétés du laser et permettant d'atteindre des puissances laser compatibles avec la génération non linéaire de THz.

On notera que l'une des spécificités du dispositif selon l'invention est d'intégrer un milieu émetteur alimenté électriquement comme source d'un processus non linéaire THz dans une microcavité microcylindre. La géométrie qui utilise les modes de galerie décrite dans le cadre de cette invention permet cette intégration. Selon l'invention, le milieu émetteur est dans le microcylindre et c'est cette intégration qui aboutit à une source THz compacte et potentiellement de faible coût.

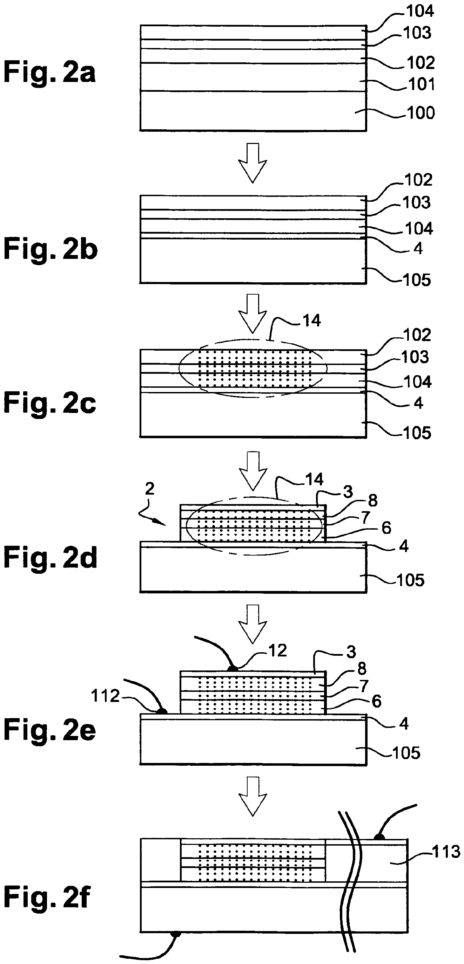

Les figures 2 a à 2 f illustrent les différentes étapes du procédé de réalisation du dispositif 1 selon l'invention.

La première étape représentée en figure 2 a est constituée par une étape de croissance épitaxiale pour l'obtention des différentes couches de l'hétérostructure semiconductrice. L'hétérostructure semiconductrice est élaborée par une technique de croissance conventionnelle, telle que l'épitaxie par jets moléculaires (EJM) ou l'épitaxie en phase vapeur à partir de composés organométalliques (EPVOM). Sur un substrat 100 en GaAs (orienté <100>), on dépose une couche tampon non représentée en GaAs, typiquement sur une épaisseur de 0,5 µm (servant à obtenir une surface présentant une meilleure qualité que la surface du substrat 100), une couche sacrificielle 101 d'AIAs (0,5 µm), puis les différentes couches semi-conductrices telles que représentées en figure 1bentre les deux miroirs métalliques, en suivant la séquence :
GaAs-p (non représenté) /AlₓGa₁₋ₓAs-p (référence 102) /GaAs-nid (référence 103) / AlₓGa₁₋ₓAs-n (référence 104) /GaAs-n (non représenté).

La croissance de la couche 103 de GaAs non intentionnellement dopée est interrompue à une ou plusieurs reprises pour y insérer les émetteurs proches-infrarouges (puits quantiques ou plans de boîtes quantiques). La fine couche de GaAs dopée n protège de l'oxydation la couche 104 d'AlₓGa₁₋ₓAs dopée n.

En référence à la figure 2b, la structure épitaxiée obtenue selon la première étape est ensuite retournée, reportée par collage sur un substrat hôte 105 préalablement métallisé par une couche de métallisation 4 (cette métallisation formant le miroir inférieur). Le substrat hôte 105 est un substrat bon conducteur de la chaleur et de l'électricité, par exemple un substrat métallique ou un substrat de GaAs dopé. Le substrat 100 de GaAs initial est ensuite aminci par abrasion mécanique, jusqu'à une épaisseur de l'ordre de 50 µm. Le substrat restant est alors éliminé par une attaque chimique sélective, en utilisant la couche 102 sacrificielle d'AlAs comme couche d'arrêt. On notera que la couche tampon de GaAs est éliminée en même temps que le substrat 100. Finalement, la couche 102 sacrificielle d'AIAs est enlevée par une nouvelle attaque chimique sélective qui dégage la surface de la couche non représentée de GaAs-p en vue des étapes technologiques ultérieures. Cette fine couche de GaAs-p protège de l'oxydation la couche 102 d'AlₓGa₁₋ₓAs dopé p sous-jacente.

La figure 2c illustre l'étape de suppression de la conductivité de la partie centrale 14 (correspondant à la partie centrale semi-isolante de l'hétérostructure cylindrique). Pour ce faire, on réalise un premier niveau de lithographie qui définit dans un masque de résine une ouverture de diamètre légèrement inférieur à celui du cylindre final de l'hétérostructure cylindrique (typiquement 1 à 2 µm en moins). On réalise alors une étape d'implantation ionique qui rend la zone non protégée semi-isolante. Si besoin, on pourra éventuellement utiliser un masque dur plus robuste vis-à-vis de l'implantation ionique. À la fin de cette étape, la résine et l'éventuel masque dur sont éliminés.

La figure 2d illustre l'étape de dépôt du miroir supérieur et de définition de la géométrie cylindrique de l'hétérostructure. On réalise pour cela un deuxième niveau de lithographie, aligné par rapport au premier, permettant de définir par un procédé de type « lift-off » le miroir métallique circulaire supérieur 3 de diamètre égal au diamètre de l'hétérostructure de forme cylindrique. Le miroir métallique supérieur 3 est ensuite utilisé directement comme masque de gravure. Ce masque de gravure 3 peut éventuellement être renforcé par le dépôt d'une couche métallique supplémentaire, par exemple du chrome. La géométrie cylindrique est ensuite définie par gravure ionique réactive RIE en utilisant un mélange de gaz chlorés. On retrouve sur la figure 2d l'hétérostructure semiconductrice 2 à géométrie cylindrique comportant de bas en haut :
- le miroir inférieur 4 ;
- la fine couche de GaAs dopée n non représentée;
- la couche 6 d'alliage AlₓGa₁₋ₓAs dopée n;
- la couche active 7 ;
- la couche 8 d'alliage AlₓGa₁₋ₓAs dopée p;
- la fine couche 9 de GaAs dopée n non représentée;
- le miroir supérieur 3 ;
- la zone centrale 14 semi-isolante.

La figure 2e illustre l'étape de prise de contact sur le miroir supérieur 3 formant électrode supérieure ; cette étape est réalisée directement par microsoudure 12 d'un fil sur le miroir supérieur 3. Il en va de même de la prise de contact sur le miroir inférieur 4 via une microsoudure 112. On notera que la microsoudure peut également être réalisée en face arrière (directement sur le substrat hôte métallique ou semiconducteur dopé) comme représenté en figure 1c.

L'étape de prise de contact peut également être réalisée conformément à la figure 2f qui suppose une étape supplémentaire de planarisation 113 et de dépôt de plots de contact déportés (étape de lithographie supplémentaire).

Le procédé de fabrication décrit ci-dessus est adapté à la réalisation en parallèle de plusieurs dispositifs selon l'invention, autorisant la réalisation de matrices d'émetteurs THz, pour des applications de génération THz de haute puissance, ou des sources à sélection de fréquences, dites sources agiles en fréquence.

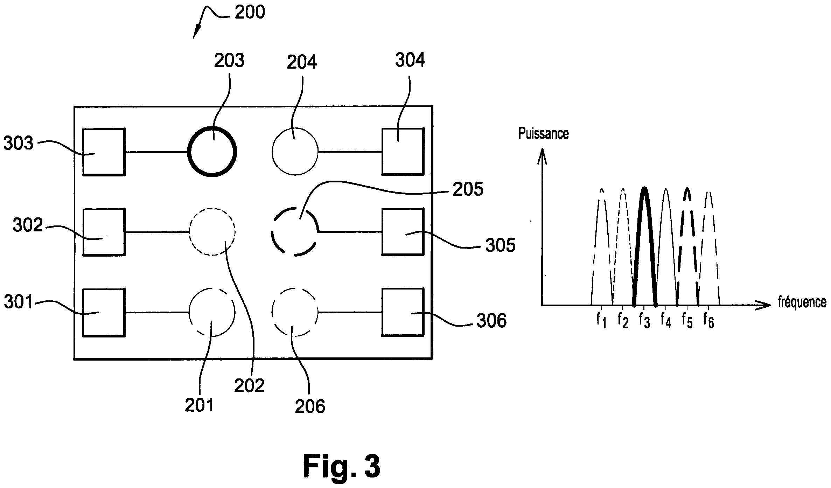

Un exemple de source 200 agile en fréquence est représenté en figure 3. Cette source 200 comporte une pluralité de dispositif THz selon l'invention ; ici six dispositifs 201 à 206 émettent à des fréquences THz différentes (respectivement f₁ à f₆) au sein de ce réseau d'émetteurs. Les émetteurs 201 à 206 de fréquences différentes sont adressables individuellement (respectivement via des moyens de commande 301 à 306) et permettent donc la réalisation de la source agile en fréquence.

On notera qu'il est également possible d'utiliser plusieurs dispositifs émetteurs THz selon l'invention au sein d'un réseau d'émetteurs en phase : L'intérêt de réaliser des réseaux d'émetteurs est double. Tout d'abord il peut être utile de disposer d'une matrice d'émetteurs identiques pour augmenter la puissance THz émise. La mise en phase des différents émetteurs peut favoriser cette augmentation. Cette mise en phase des différents émetteurs peut être obtenue de deux façons différentes :
1) en rapprochant les différents dispositifs émetteurs THz selon l'invention à une fraction de longueur d'onde (quelques microns) les uns des autres de manière à coupler les champs évanescents THz des différents dispositifs.
2) en utilisant un dispositif optique qui réinjecte une partie de la radiation THz émise par la matrice de dispositifs émetteurs dans la matrice elle-même.

Bien entendu, le dispositif et le procédé selon l'invention ne sont pas limités aux modes de réalisation qui viennent d'être décrits à titre indicatif et nullement limitatif en référence aux figures 1 à 3.

Notamment, l'hétérostructure semiconductrice à géométrie cylindrique pourrait par exemple être réalisée dans une autre famille de matériaux semiconducteurs III-V ou II-VI. Un système particulièrement intéressant est le système InGaAsP/InP, très employé pour réaliser des microlasers fonctionnant à température ambiante, du fait de la relativement faible efficacité des mécanismes de recombinaison non radiative en surface dans ce système. On pourrait par exemple employer une structure à guide d'onde du type InP :n/ InGaAsP/ InP :p, et des puits quantiques en InGaAs ou des boîtes quantiques en InAs comme milieu émetteur.

L'hétérostructure semiconductrice pourra également être modifiée de façon à optimiser le confinement optique du mode guidé proche infrarouge, ou à faciliter l'injection électrique dans la structure. Les solutions technologiques développées pour les diodes lasers conventionnelles, telles que les couches de confinement à composition graduelle (structures GRINSCH) pourront naturellement être mises en oeuvre ici.

Par ailleurs, dans le mode de réalisation décrit précédemment, le guide d'onde est monomode TE et les deux modes proche-infrarouge impliqués dans la génération paramétrique sont du type TE_{1,1,m} (comme mentionné plus haut, les deux premiers indices désignent l'ordre du mode suivant la direction verticale du cylindre et suivant son rayon, et m désigne l'ordre azimutal du mode). Cependant, le cylindre possède d'autres modes de galerie, d'indice radial supérieur qui peuvent être également exploités. De plus, en augmentant l'épaisseur de la couche centrale de GaAs ou la composition en aluminium des couches de confinement en AlGaAs, on peut augmenter le nombre de modes guidés. Pour un guide ayant k modes guidés TE, le cylindre possédera k familles de modes de galerie du type {TE_{h,n,m}} (avec n et m fixés, et h nombre entier compris entre 1 et k). L'existence de ces familles de modes de galerie supplémentaires ouvre le choix des combinaisons possibles pour réaliser l'accord de phase pour la génération THz par différence de fréquence.

Comme nous l'avons déjà expliqué en référence à la figure 1, il est aussi possible d'utiliser un seul miroir métallique pour confiner le mode THz On peut alors remplacer l'autre couche métallique par une couche semiconductrice dopée, qui a également des propriétés de guidage des ondes THz. L'intérêt de cette déclinaison est qu'elle permet d'éviter l'étape de technologique de report de la structure sur un autre substrat. Une couche semiconductrice dopée est alors insérée lors de la croissance (figure 2a), et remplace finalement la couche métallique du dessous de la structure. L'étape correspondant à la figure 2b de report sur un autre substrat est supprimée, on conserve le substrat de la croissance. Le reste du procédé de réalisation est identique.

On notera également que le dispositif selon l'invention décrit jusqu'à présent permet un pompage électrique du milieu actif. Ce pompage peut être réalisé par voie optique, avec un laser. Dans ce cas, les couches dopées n et p servant à la structure semiconductrice pour l'injection électrique des porteurs ainsi que l'étape d'implantation ionique ne sont pas nécessaires. En revanche, la déclinaison décrite ci-dessus de substitution de la couche métallique du dessous par une couche de semiconducteur dopé est particulièrement intéressante dans ce cas-là, avec une couche semiconductrice dopée transparente au pompage optique. L'intégration, par exemple par collage, de ce dispositif selon l'invention à l'extrémité d'une fibre optique transportant le faisceau de pompe permettrait d'obtenir une source THz compacte, pompée optiquement. Une telle source en bout de fibre optique pourrait par exemple être utilisée pour réaliser un endoscope THz pour l'analyse médicale.

Le dispositif selon l'invention fonctionne à température ambiante. Toutefois, il est aussi envisageable d'intégrer ce dispositif dans un système cryogénique (dans un cryostat ou sur une embase de type refroidisseur à effet Peltier). La température peut être employée comme paramètre de contrôle additionnel, afin de réaliser et d'ajuster finement la condition d'accord de phase. Par ailleurs, le fonctionnement à basse température permet de diminuer la largeur homogène des boîtes quantiques et favoriser un comportement multimode du laser. Ceci peut permettre d'utiliser des microcavités plus grandes, et donc des modes de galerie plus proches en fréquence. En rapprochant ainsi les fréquences laser, on peut donc atteindre des fréquences THz plus faibles. Le fonctionnement à basse température peut aussi permettre d'améliorer les performances du dispositif laser (abaissement du courant de seuil, augmentation du rendement de conversion électrique-optique).

Nous avons vu que le milieu émetteur pouvait contenir un ou des plans de boîtes quantiques ou un ou plusieurs puits quantiques. Il est également possible d'utiliser un milieu à gain à cascade quantique. Il est connu de l'homme du métier que les lasers à cascade quantique présentent également des potentialités d'émission multimode ; à titre d'exemple un laser à cascade quantique émettant simultanément à deux longueurs d'ondes différentes dans le moyen infrarouge sans compétition de mode a été démontré dans le document "Evidence of cascaded emission in a dual-wavelength quantum cascade laser" (K. J. Franz et al.,Appl. Phys. Lett. 90, 091104 (2007)). On peut donc remplacer dans l'invention les boîtes quantiques ou les puits quantiques par des structures à cascade quantique. Les polarisations des deux ondes laser à cascade quantique sont TM. Pour optimiser le coefficient non linéaire, l'emploi d'une hétérostructure semiconductrice ayant une orientation cristalline différente (croissance sur une face (111) d'un substrat de GaAs par exemple) peut alors être avantageux.

Enfin, on distingue traditionnellement deux régimes pour une génération paramétrique de lumière en cavité, ici par différence de fréquence, selon que le nombre moyen de photons dans le mode est -ou non- supérieur à 1. Dans le premier cas, le système est dans le régime d'oscillation paramétrique, qui est favorable pour générer de fortes puissances THz. Ces deux régimes de fonctionnement, qui peuvent a priori être obtenus pour une même structure selon qu'elle est pompée « faiblement » ou « fortement », sont considérés tous deux comme conformes à l'invention.

## Revendications

1. Dispositif (1) laser d'émission d'onde dans une gamme de fréquence comprise entre 0,5 THz et 5 THz comportant une hétérostructure semiconductrice (2), ladite hétérostructure (2) étant de forme cylindrique à section circulaire, et comportant :
- une première couche (7) en matériau semiconducteur optiquement non linéaire incluant des moyens émetteurs (10, 11), une deuxième (8) et une troisième (6) couche en matériau semiconducteur présentant chacune un indice optique plus faible que l'indice du matériau utilisé pour ladite première couche (7) et situées de part et d'autre de ladite première couche (7); au moins une couche métallique (3, 4) située à une extrémité de ladite hétérostructure (2), **caractérisée en ce que** ces moyens émetteurs sont aptes à émettre dans au moins deux modes de galerie optiques appartenant au proche infrarouge, lesdits au moins deux modes de galerie étant confinés dans ladite première couche (7) et permettant la génération au sein de ladite première couche (7) d'un rayonnement dans un mode de galerie électromagnétique de fréquence comprise entre 0,5 THz et 5 THz, dit mode Térahertz, ledit rayonnement étant obtenu par différence des fréquences desdits deux modes de galerie, la géométrie cylindrique de ladite hétérostructure assurant l'accord de phase entre les deux modes de galerie optiques appartenant au proche infrarouge et le mode Térahertz à la fréquence différence.

2. Dispositif (1) selon la revendication précédente **caractérisé en ce que** ladite hétérostructure (2) de forme cylindrique comporte une zone centrale semi-isolante (14) s'étendant sensiblement entre les deux extrémités de ladite hétérostructure (2).

3. Dispositif (1) selon l'une des revendications précédentes **caractérisé en ce que** ledit dispositif (1) comporte deux couches métalliques (3, 4) situées chacune à une extrémité de ladite hétérostructure (2).

4. Dispositif (1) selon l'une des revendications précédentes **caractérisé en ce que** ladite ou lesdites couches métalliques (3, 4) sont réalisées en or.

5. Dispositif (1) selon l'une des revendications précédentes **caractérisé en ce que** lesdits moyens émetteurs sont réalisés selon l'une des formes suivantes :
- un ou une pluralité de puits quantiques ;
- un ou une pluralité de plans (10) de boites quantiques (11);
- une ou une pluralité de structures à cascade quantique.

6. Dispositif (1) selon l'une des revendications précédentes **caractérisé en ce que** ledit matériau semiconducteur optiquement non linéaire de ladite première couche (7) est un matériau III-V tel que le GaAs ou InGaAsP ou un matériau II-VI.

7. Dispositif (1) selon l'une des revendications précédentes **caractérisé en ce que** le matériau semiconducteur desdites deuxième et troisième couche (8, 6) est du AlₓGa₁₋ₓAs avec 0,2<x<0,6 ou de l'InP.

8. Dispositif selon l'une des revendications précédentes **caractérisé en ce que** ladite deuxième couche (8) semiconductrice est une couche dopée p et ladite troisième couche (6) semiconductrice est une couche dopée n.

9. Dispositif (1) selon l'une des revendications précédentes **caractérisé en ce que** ladite première couche (7) inclut une pluralité de plans (10) d'émetteurs.

10. Dispositif (1) selon l'une des revendications précédentes **caractérisé en ce que** ladite hétérostructure (2) de forme cylindrique comporte deux couches semi-conductrices (9, 5), dites couches de protection contre l'oxydation, recouvrant respectivement lesdites deuxième (8) et troisième couches (6).

11. Dispositif (1) selon la revendication précédente **caractérisé en ce que** chacune desdites couches de protection (9, 5) contre l'oxydation a une épaisseur comprise entre 2 et 10 nm.

12. Dispositif (1) selon l'une des revendications précédentes **caractérisé en ce que** l'épaisseur desdites deuxième (8) et troisième (6) couche est comprise entre 0,5 et 5 µm.

13. Dispositif (1) selon l'une des revendications précédente **caractérisé en ce qu'**il comporte deux contacts électriques (12, 13) pour l'injection d'un courant de pompage desdits moyens émetteurs (10, 11).

14. Dispositif (1) selon l'une des revendications précédentes **caractérisé en ce que** l'épaisseur de ladite première couche (7) est comprise entre 200 et 400 nm.

15. Dispositif (1) selon l'une des revendications précédentes **caractérisé en ce que** le diamètre de ladite hétérostructure cylindrique (2) est compris entre 30 et 100 µm.

16. Dispositif (1) selon l'une des revendications précédentes **caractérisé en ce que** ladite première couche (7) est une couche non intentionnellement dopée.

17. Système cryogénique intégrant un dispositif selon l'une des revendications 1 à 16.

18. Réseau comportant une pluralité de dispositifs selon l'une des revendications 1 à 16 **caractérisé en ce que** chacun desdits dispositifs présente sensiblement la même fréquence.

19. Réseau selon la revendication 18 **caractérisé en ce que** lesdits dispositifs sont suffisamment proches les uns des autres pour coupler les champs évanescents THz des différents dispositifs.

20. Réseau selon la revendication 18 **caractérisé en ce qu'**une partie du rayonnement THz émis par ledit réseau est réinjectée dans ledit réseau.

21. Réseau (200) comportant une pluralité de dispositifs (201, 202, 203, 204, 205, 206) selon l'une des revendications 1 à 16 **caractérisé en ce que** chacun desdits dispositifs (201, 202, 203, 204, 205, 206) présente des fréquences THz différentes, chacun desdits dispositifs étant commandés individuellement.

22. Procédé de réalisation d'un dispositif selon l'une des revendications précédentes **caractérisé en ce qu'**il comporte les étapes suivantes :
- Croissance épitaxiale par dépôt sur un substrat semiconducteur d'une structure comportant au moins les couches suivantes dans cet ordre à partir du substrat :
• une couche semiconductrice sacrificielle ;
• une première couche semiconductrice de protection ;
• une couche réalisée dans un matériau semiconducteur identique à celui de ladite deuxième couche ;
• une couche réalisée dans un matériau semiconducteur identique à celui de ladite première couche, ladite couche comportant des moyens émetteurs ;
• une couche réalisée dans un matériau semiconducteur identique à celui de ladite troisième couche ;
• une deuxième couche semiconductrice de protection ;
- Report sur un substrat hôte préalablement métallisé de ladite structure épitaxiée de sorte que la deuxième couche de protection est en contact avec le métal dudit substrat hôte;
- Amincissement dudit substrat semiconducteur par abrasion mécanique ;
- Attaque chimique sélective dudit substrat sur l'épaisseur restante, ladite couche sacrificielle étant utilisée comme couche d'arrêt ;
- Attaque chimique sélective de ladite couche sacrificielle, ladite première couche de protection étant utilisée comme couche d'arrêt ;
- Réalisation d'un masque définissant une ouverture de diamètre inférieure au diamètre de l'hétérostructure de forme cylindrique ;
- Implantation ionique rendant semi-isolante la zone non protégée par ledit masque ;
- Elimination dudit masque ;
- Dépôt d'une couche métallique circulaire de diamètre égal au diamètre de l'hétérostructure de forme cylindrique;
- Gravure des parties non recouvertes par ladite couche métallique circulaire de façon à former l'hétérostructure de forme cylindrique.

23. Procédé selon la revendication précédente **caractérisé en ce que** ledit masque définit une ouverture de diamètre inférieur de 1 à 2 µm au diamètre de l'hétérostructure de forme cylindrique.

## Claims

1. A wave-emitting laser device (1) in a frequency range of between 0.5 THz and 5 THz comprising a semiconductor heterostructure (2), said heterostructure (2) being cylindrical in form with a circular cross-section and comprising:
a first layer (7) of an optically non-linear semiconductor material including emitting means (10, 11), a second (8) and a third (6) layer of semiconductor material, each exhibiting a lower optical index than that of the material used for said first layer (7) and disposed on either side of said first layer (7), at least one metallic layer (3, 4) situated at one end of said heterostructure (2), **characterized in that** these emitting means are capable of emitting in at least two optical whispering gallery modes in the near infrared, said at least two whispering gallery modes being confined within said first layer (7) and allowing the generation within said first layer (7) of radiation in an electromagnetic whispering gallery mode with a frequency of between 0.5 THz and 5 THz, referred to as terahertz mode, said radiation being obtained through the difference between the frequencies of said two whispering gallery modes, the cylindrical geometry of said heterostructure guaranteeing phase matching between the two optical whispering gallery modes belonging to the near infrared spectrum and the terahertz mode at the difference frequency.

2. The device (1) according to the preceding claim, **characterized in that** said cylindrical heterostructure (2) comprises a semi-insulating central zone (14) extending substantially between the two ends of said heterostructure (2).

3. The device (1) according to one of the preceding claims, **characterized in that** said device (1) comprises two metallic layers (3, 4), each situated at one end of said heterostructure (2).

4. The device (1) according to one of the preceding claims, **characterized in that** said transmitting metallic layer or layers (3, 4) is/are made from gold.

5. The device (1) according to one of the preceding claims, **characterized in that** said emitting means are realized according to one of the following forms:
- one or a plurality of quantum wells;
- one or a plurality of designs (10) of quantum dots (11);
- one or a plurality of quantum cascade structures.

6. The device (1) according to one of the preceding claims, **characterized in that** said optically non-linear semiconductor material of said first layer (7) is an III-V material such as GaAs or InGaAsP or an II-VI material.

7. The device (1) according to one of the preceding claims, **characterized in that** the semiconductor material of said second and third layer (8, 6) is AlₓGa₁₋ₓAs with 0.2<x<0.6 or InP.

8. The device according to one of the preceding claims, **characterized in that** said second semiconductor layer (8) is a doped layer p and said third semiconductor layer (6) is a doped layer n.

9. The device (1) according to one of the preceding claims, **characterized in that** said first layer (7) includes a plurality of emitting planes (10).

10. The device (1) according to one of the preceding claims, **characterized in that** said cylindrical heterostructure (2) comprises two semiconductor layers (9, 5), referred to as oxidation protection layers, covering said second (8) and third (6) layers, respectively.

11. The device (1) according to the preceding claim, **characterized in that** each of said oxidation protection layers (9, 5) has a thickness of between 2 and 10 nm.

12. The device (1) according to one of the preceding claims, **characterized in that** the thickness of said second (8) and third (6) layer is included between 0.5 and 5 µm.

13. The device (1) according to one of the preceding claims, **characterized in that** it comprises two electrical contacts (12, 13) for the injection of a pumping current of said emitting means (10, 11).

14. The device (1) according to one of the preceding claims, **characterized in that** the thickness of said first layer (7) is included between 200 and 400 nm.

15. The device (1) according to one of the preceding claims, **characterized in that** the diameter of said cylindrical heterostructure (2) is included between 30 and 100 µm.

16. The device (1) according to one of the preceding claims, **characterized in that** said first layer (7) is an unintentionally doped layer.

17. A cryogenic system incorporating a device according to one of the claims 1 to 16.

18. A network comprising a plurality of devices according to one of the claims 1 to 16, **characterized in that** each of said devices exhibits substantially the same frequency.

19. The network according to claim 18, **characterized in that** said devices are sufficiently close to one another to couple the THz evanescent fields of the different devices.

20. The network according to claim 18, **characterized in that** part of the THz radiation emitted by said network is re-injected into said network.

21. The network (200) comprising a plurality of devices (201, 202, 203, 204, 205, 206) according to one of the claims 1 to 16, **characterized in that** each of said devices (201, 202, 203, 204, 205, 206) exhibits different THz frequencies, each of said devices being controlled individually.

22. A method of realizing a device according to one of the preceding claims, **characterized in that** it comprises the following stages:
- Epitaxial growth through the depositing on a semiconductor substrate of a structure at least comprising the following layers in this order, starting with the substrate:
• a sacrificial semiconductor layer;
• a first protective semiconductor layer;
• a layer made in a semiconductor material identical to that of said second layer;
• a layer made in a semiconductor material identical to that of said first layer, said layer comprising emitting means;
• a layer made in a semiconductor material identical to that of said third layer;
• a second protective semiconductor layer;
- transfer on a previously metallized host substrate of said epitaxial structure, such that the second protective layer is in contact with the metal of said host substrate;
- thinning of said semiconductor substrate by mechanical abrasion;
- selective chemical attack of said substrate on the remaining thickness, said sacrificial layer being used as a stop layer;
- selective chemical attack of said sacrificial layer, said first protective layer being used as a stop layer;
- production of a mask defining an opening with a diameter smaller than the diameter of the cylindrical heterostructure;
- ionic implantation making the zone left unprotected by said mask semi-insulating;
- elimination of said mask;
- deposition of a circular metallic layer with a diameter equal to the diameter of the cylindrical heterostructure;
- etching of the parts left uncovered by said circular metallic layer, so as to form the cylindrical heterostructure.

23. The method according to the preceding claim, **characterized in that** said mask defines an opening with a diameter 1 to 2 µm smaller than the diameter of the cylindrical heterostructure.

## Patentansprüche

1. Laser-Vorrichtung (1) zum Ausstrahlen von Wellen in einem Frequenzbereich, der zwischen 0,5 THz und 5 THz enthalten ist, die eine Halbleiter-Heterostruktur (2) umfasst, wobei die Heterostruktur (2) eine zylindrische Form mit kreisförmigem Querschnitt aufweist und Folgendes umfasst:
eine erste Schicht (7) aus optisch nichtlinearem Halbleitermaterial, die Ausstrahlungsmittel (10, 11) umfasst, eine zweite (8) und eine dritte (6) Schicht aus Halbleitermaterial, die jeweils einen Brechungsindex aufweisen, der niedriger ist als der Index des für die erste Schicht (7) verwendeten Materials, und sich auf beiden Seiten der ersten Schicht (7) befinden, und mindestens eine metallische Schicht (3, 4), die sich an einem Ende der Heterostruktur (2) befindet, **dadurch gekennzeichnet, dass** diese Ausstrahlungsmittel geeignet sind, um in mindestens zwei optischen Flüstergaleriemoden auszustrahlen, die dem nahen Infrarotbereich angehören, wobei die mindestens zwei optischen Flüstergaleriemoden in der ersten Schicht (7) eingeschlossen sind und innerhalb der ersten Schicht (7) die Erzeugung einer Strahlung in einer elektromagnetischen Flüstergaleriemode mit einer Frequenz ermöglichen, die zwischen 0,5 THz und 5 THz enthalten ist, die Terahertz-Mode genannt wird, wobei die Strahlung durch Differenz der Frequenzen der zwei Flüstergaleriemoden erhalten wird, wobei die zylindrische Geometrie der Heterostruktur die Phasenanpassung zwischen den zwei optischen Flüstergaleriemoden, die zum nahen Infrarotbereich gehören, und der Terahertz-Mode bei der Differenzfrequenz gewährleistet.

2. Vorrichtung (1) nach dem vorhergehenden Anspruch, **dadurch gekennzeichnet, dass** die Heterostruktur (2) mit zylindrischer Form einen semiisolierenden mittleren Bereich (14) umfasst, der sich im Wesentlichen zwischen den zwei Enden der Heterostruktur (2) erstreckt.

3. Vorrichtung nach einem der vorhergehenden Ansprüche, **dadurch gekennzeichnet, dass** die Vorrichtung (1) zwei metallische Schichten (3, 4) umfasst, die sich jeweils an einem Ende der Heterostruktur (2) befinden.

4. Vorrichtung (1) nach einem der vorhergehenden Ansprüche, **dadurch gekennzeichnet, dass** die Metallschicht oder Metallschichten (3, 4) aus Gold hergestellt ist/sind.

5. Vorrichtung (1) nach einem der vorhergehenden Ansprüche, **dadurch gekennzeichnet, dass** die Ausstrahlungsmittel in einer der folgenden Formen hergestellt sind:
- einer oder mehrere Quantentöpfe;
- eine oder mehrere Ebenen (10) von Quantenpunkten (11);
- eine oder mehrere Quantenkaskadenstrukturen.

6. Vorrichtung (1) nach einem der vorhergehenden Ansprüche, **dadurch gekennzeichnet, dass** das optisch nichtlineare Halbleitermaterial der ersten Schicht (7) ein III-V-Material, wie zum Beispiel GaAs oder InGaAsP, oder ein II-VI-Material ist.

7. Vorrichtung (1) nach einem der vorhergehenden Ansprüche, **dadurch gekennzeichnet, dass** das Halbleitermaterial der zweiten und dritten Schicht (8, 6) AlₓGA₁₋ₓAs mit 0,2 2 < x < 0,6 oder InP ist.

8. Vorrichtung nach einem der vorhergehenden Ansprüche, **dadurch gekennzeichnet, dass** die zweite Halbleiterschicht (8) eine p-dotierte Schicht ist und die dritte Halbleiterschicht (6) eine n-dotierte Schicht ist.

9. Vorrichtung (1) nach einem der vorhergehenden Ansprüche, **dadurch gekennzeichnet, dass** die erste Schicht (7) mehrere Ebenen (10) von Strahlern umfasst.

10. Vorrichtung (1) nach einem der vorhergehenden Ansprüche, **dadurch gekennzeichnet, dass** die Heterostruktur (2) mit zylindrischer Form zwei Halbleiterschichten (9, 5) umfasst, die Oxidationsschutzschichten genannt werden und die zweite (8) beziehungsweise dritte (6) Schicht bedecken.

11. Vorrichtung (1) nach dem vorhergehenden Anspruch, **dadurch gekennzeichnet, dass** jede der Oxidationsschutzschichten (9, 5) eine Dicke aufweist, die zwischen 2 und 10 nm enthalten ist.

12. Vorrichtung (1) nach einem der vorhergehenden Ansprüche, **dadurch gekennzeichnet, dass** die Dicke der zweiten (8) und dritten (6) Schicht zwischen 0,5 und 5 µm enthalten ist.

13. Vorrichtung (1) nach einem der vorhergehenden Ansprüche, **dadurch gekennzeichnet, dass** sie zwei elektrische Kontakte (12, 13) zur Injektion eines Stroms zum Pumpen der Ausstrahlungsmittel (10, 11) umfasst.

14. Vorrichtung (1) nach einem der vorhergehenden Ansprüche, **dadurch gekennzeichnet, dass** die Dicke der ersten Schicht (7) zwischen 200 und 400 nm enthalten ist.

15. Vorrichtung (1) nach einem der vorhergehenden Ansprüche, **dadurch gekennzeichnet, dass** der Durchmesser der zylindrischen Heterostruktur (2) zwischen 30 und 100 µm enthalten ist.

16. Vorrichtung (1) nach einem der vorhergehenden Ansprüche, **dadurch gekennzeichnet, dass** die erste Schicht (7) eine nicht absichtlich dotierte Schicht ist.

17. Kryosystem, das eine Vorrichtung nach einem der Ansprüche 1 bis 16 umfasst.

18. Netz, das mehrere Vorrichtungen nach einem der Ansprüche 1 bis 16 umfasst, **dadurch gekennzeichnet, dass** jede der Vorrichtungen im Wesentlichen dieselbe Frequenz aufweist.

19. Netz nach Anspruch 18, **dadurch gekennzeichnet, dass** die Vorrichtungen sich ausreichend nahe beieinander befinden, um die abklingenden THz-Felder der verschiedenen Vorrichtungen zu koppeln.

20. Netz nach Anspruch 18, **dadurch gekennzeichnet, dass** ein Teil der durch das Netz ausgestrahlten THz-Strahlung wieder in das Netz injiziert wird.

21. Netz (200), das mehrere Vorrichtungen (201, 202, 203, 204, 205, 206) nach einem der Ansprüche 1 bis 16 umfasst, **dadurch gekennzeichnet, dass** jede der Vorrichtungen (201, 202, 203, 204, 205, 206) verschiedene THz-Frequenzen aufweist, wobei jede der Vorrichtungen einzeln gesteuert wird.

22. Verfahren zur Herstellung einer Vorrichtung nach einem der vorhergehenden Ansprüche, **dadurch gekennzeichnet, dass** es die folgenden Schritte umfasst:
- epitaktisches Wachstum, indem auf einem Halbleitersubstrat eine Struktur aufgebracht wird, die ausgehend vom Substrat mindestens die folgenden Schichten in dieser Reihenfolge umfasst:
• eine Halbleiter-Opferschicht;
• eine erste Halbleiter-Schutzschicht;
• eine Schicht, die aus einem Halbleitermaterial hergestellt wird, das identisch mit demjenigen der zweiten Schicht ist;
• eine Schicht, die aus einem Halbleitermaterial hergestellt wird, das identisch mit demjenigen der ersten Schicht ist, wobei die Schicht Ausstrahlungsmittel umfasst;
• eine Schicht, die aus einem Halbleitermaterial hergestellt wird, das identisch mit demjenigen der dritten Schicht ist;
• eine zweite Halbleiterschutzschicht;
- Auftragen der epitaktischen Struktur auf einem vorhergehend metallisierten Wirtssubstrat, derart, dass die zweite Schutzschicht mit dem Metall des Wirtssubstrats in Berührung ist;
- Abdünnen des Halbleitersubstrats durch mechanisches Abschleifen;
- selektives chemisches Ätzen des Substrats auf der verbleibenden Dicke, wobei die Opferschicht als Sperrschicht verwendet wird;
- selektives chemisches Ätzen der Opferschicht, wobei die erste Schutzschicht als Sperrschicht verwendet wird;
- Herstellen einer Maske, die eine Öffnung abgrenzt, deren Durchmesser kleiner ist als der Durchmesser der Heterostruktur mit zylindrischer Form;
- Ionenimplantation, die den nicht durch die Maske geschützten Bereich semiisolierend macht;
- Entfernen der Maske;
- Aufbringen einer kreisförmigen metallischen Schicht mit einem Durchmesser, der gleich dem Durchmesser der Heterostruktur mit zylindrischer Form ist;
- Gravur der nicht durch die kreisförmige metallische Schicht bedeckten Abschnitte, derart, dass die Heterostruktur mit zylindrischer Form gebildet wird.

23. Verfahren nach dem vorhergehenden Anspruch, **dadurch gekennzeichnet, dass** die Maske eine Öffnung mit einem Durchmesser abgrenzt, der um 1 bis 2 µm kleiner ist als der Durchmesser der Heterostruktur mit zylindrischer Form.
